# EUROPEAN PATENT SPECIFICATION

(11) **EP 1 727 876 B1**
(45) Date of publication and mention of the grant of the patent: **23.04.2008**
(21) Application number: 05708896.5
(22) Date of filing: 02.03.2005
(51) Int. Cl.: C09K 11/06

(54) **ELECTROLUMINESCENT COMPOSITION WITHOUT INITIAL DROP OF EFFICIENCY**
ELEKTROLUMINESZIERENDE ZUSAMMENSETZUNG OHNE ANFÄNGLICHEN WIRKUNGSVERLUST
COMPOSITION ELECTROLUMINESCENTE SANS PERTE DE RENDEMENT INITIAL

(30) Priority: 09.03.2004 EP 04100957
(43) Date of publication of application: 06.12.2006
(73) Proprietor: Koninklijke Philips Electronics N.V., 5621 BA Eindhoven (NL)
(72) Inventor: VULTO, Simone, I., E., NL-5656 AA Eindhoven (NL); MEULENKAMP, Eric, A., NL-5656 AA Eindhoven (NL); VAN DE WEIJER, Peter, NL-5656 AA Eindhoven (NL); DE KOK-VAN BREEMEN, Margaretha, M., NL-5656 AA Eindhoven (NL); BUECHEL, Michael, NL-5656 AA Eindhoven (NL)
(74) Representative: Tol, Arie Jan Willem
(86) International application number: PCT/IB2005/050758
(87) International publication number: WO 2005/087893

(56) References cited:
- US-A- 5 629 389
- US-A- 5 965 281
- WEIJER ET AL: "Initial Drop of Efficiency in Polymer Light Emitting Diodes" INT. CONF. SCI. TECHNOL. EMISSIVE DISPLAYS AND LIGHTING, 2002, pages 1-4, XP002325620 cited in the application

## Description

The invention relates to an electroluminescent composition comprising an electroluminescent material containing an aryl vinylene and in particular to an electroluminescent device comprising such composition.

An electroluminescent device is characterized in that it emits light when an electrical voltage is applied and current flows. Such devices have long been known in engineering as light-emitting diodes (LEDs). The emission of light is due to the fact that positive charges ("holes") and negative charges ("electrons") recombine with the emission of light.

In the development of light-emitting components for electronics or photonics, use was made of inorganic semiconductors, such as gallium arsenide. In addition to semiconductor light-emitting diodes, organic LED's (OLED's) based on vapour-deposited low-molecular-weight organic compounds were developed. Recently, oligomers and polymers, based on e.g. substituted p-divinylbenzene, poly(p-phenylenes) and poly(p-phenylenevinylenes) (PPV), polyfluorenes and poly(spirofluorene)s are described for the manufacturing of a polymer LED (polyLED)

In the simplest case, a polyLED comprises two electrodes between which an organic layer is situated, fulfilling the function of the emission of light. Such systems, for example on the basis of a poly-(phenylenevinylene), are described in Patent Application WO-A-0134722.

Since the discovery of polyLEDs operational lifetimes thereof have been increased from a few hours to many years. When operating a device in constant current mode, the operational lifetime is defined as the time elapsed until the emitted light has decreased to 50% of its original value. The efficiency of an electroluminescent device is understood to be the amount of light (in Cd) emitted per unit of current (A). A substantial part of the decrease in efficiency occurs, however, in a small fraction of the operational lifetime. This decrease in efficiency is called the initial drop. A major drawback of the initial drop phenomenon becomes apparent when OLEDs or polyLEDs are applied in a matrix display with multiple pixels. As a result of the difference in load between the pixels, differential ageing may occur in the very first stage of the lifetime of these light emitting devices. The effect of differential aging is visible as an inconvenient difference in brightness between groups of pixels. The initial drop is defined as the fractional decay in efficiency with respect to the initial efficiency during the first 10 hours of operation at constant current. Typical amplitude for e.g. a PPV based polymer, is 0.25 - 0.30, for an initial luminance of a few 100 Cd/m².

In order to prevent differential ageing as a result of the initial drop in a matrix display, a bum-in procedure was proposed by P. v.d. Weijer et al, "Initial drop of efficiency in Polymer Light Emitting Diodes", OLED Conference, Gent 2002. As an electrical bum-in procedure of many hours is not acceptable for an industrial process, an accelerated procedure can be applied at a device current that is typically an order of magnitude larger than the current needed in the application. This approach reduces the time required for bum-in more than proportionally to about half an hour.

However, the above-mentioned burn-in procedure still has a number of disadvantages; (1) The bum-in procedure reduces the efficiency of the device by an amount more than the amplitude of the initial drop itself and (2) the burn-in procedure is still considered as substantial effort during the production process. (3) The effect of burn-in gradually disappears over time due to the reversible nature of initial drop. (4) For certain product lay-outs (e.g. full-colour matrix displays), electrical burn-in has to be done separately for every display and for each colour individually, adding greatly to the burn-in effort and costs.

It is an aim of the present invention to provide an electroluminescent composition without a substantial initial drop in efficiency and without affecting the operational lifetime.

These and other objects of the invention are achieved, by an electroluminescent composition comprising an electroluminescent material containing an aryl vinylene and an additive for suppressing a drop in initial light emission efficiency observed when an electroluminescent device comprising the electroluminescent material as such is driven to emit light. Surprisingly it has been found that the electrical bum-in procedure can be replaced by adding a chemical compound to the electroluminescent material. Thus, the composition includes an additive for suppressing a drop in the initial efficiency of light emission. Adding the additive does not adversely affect the operational lifetime, with respect to the lifetime of an electroluminescent material used as such. The additive for suppressing a drop in the initial efficiency of light emission is generally added in amount such that the initial drop is suppressed without significant decrease of the operational lifetime with respect to the lifetime of an electroluminescent material used as such. A significant decrease of the operational lifetime means that the lifetime of the electroluminescent material does not decrease by more than 25 % preferably not more than 10 % of the lifetime of the electroluminescent material used as such. A suitable amount of additive varies between 0.1 and 6 % by weight with respect to the concentration of the electroluminescent material in the solution.

Although the use of additives in electroluminescent materials is known for several purposes, none of these describes, or is suitable for a suppression of the initial drop.

The use of additives in the form of an electron trap in electroluminescent materials is known for enhancing the efficiency for example from US 2003/0209974. However these materials have no effect on the initial drop of the electroluminescent material. Additives like UV-stabilizers, antioxidants as described in EP-A- 0764712 to improve the long term stability of organic electroluminescent materials also have no effect on the initial drop. No effect on the initial drop is found from hindered phenolic additives, which according to US 5,629,389, increase the lifetime and/or the efficiency of a polyLED.

An additive suitable to suppress the initial drop preferably comprises an oligo ring structure with at least four carbonyl groups. The invention therefore also relates to an electroluminescent composition comprising an electroluminescent material, preferably containing an aryl vinylene and an additive, wherein the additive comprises an oligo ring structure with at least four carbonyl groups. An advantage of an additive comprising an oligo ring structure with at least four carbonyl groups is that these additives have no influence on the efficiency after the initial drop.

Preferably, the electroluminescent material according to the invention comprises at least three fused rings. Examples of these additives are compounds according to the following structures:

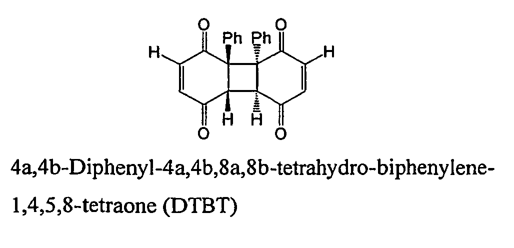

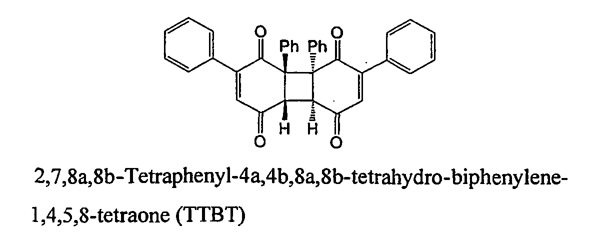

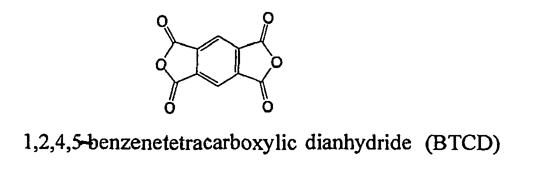

OLEDs and polyLEDs are generally made via chemical vapour deposition and solution processing of a solution of an electroluminescent material on a support respectively. Concentrations required for the additive depend on the light emitting material, the additive and the driving conditions of the device. Typical concentrations for the additives are between 0.1 and 3 % by weight with respect to the concentration of the electroluminescent material in the solution. At higher concentrations of the additive a negative drop, so an initial increase of the efficiency may occur. Between 0.1 % and 3 % generally a concentration can be found at which the initial drop can be suppressed to a level at which the efficiency is sufficiently constant to avoid differences in brightness between groups of pixels. Concentrations are expressed in weight percent with respect to the polymer concentration. So for 1 litre of polymer (0.4%, 4g/l) only 4 (0.1 %) to 120 ( 3%) mg of additive is needed.

The electroluminescent material of the invention comprises an aryl vinylene containing electroluminescent material. These materials generally comprise substituted or not aryl vinylenic monomers, oligomers or polymers. Preferably the aryl vinylene containing material comprises a substituted poly(p-phenylene vinylene) or a substituted oligo phenyl vinylene.

The invention also relates to an electroluminescent device comprising an electroluminescent composition according to the invention.

The invention will further be elucidated in the following drawings, Examples and Comparative Experiments.

In the drawings:
Fig. 1 shows the efficiency (in Cd/A) as a function of drive time (in hours) on a linear scale (left hand graph) and log scale (graph on the right) for an electroluminescent device comprising an electroluminescent composition having various amount of additive; and
Fig. 2 shows the efficiency (in Cd/A) as a function of drive time (in hours) for an electroluminescent device comprising an electroluminescent composition having various amount of another additive in accordance with the invention.

### Device

Standard polyLED devices were made, with 150 nm ITO (indium tin oxide), 200 nm Pedot:PPS (poly-3,4-ethylenedioxythiophene doped with poly(styrene sulfonate)), 80 nm yellow poly(p-phenylenevinylene) (PPV) and a Ba/Al cathode. Different additives were added to the polymer in various concentrations. The light-emitting polymer is a PPV-based yellow light-emitting polymer available under the trade name "SUPER YELLOW" from Covion Organic Semiconductors GmbH.

### Initial drop test:

For an initial drop test single pixel devices based on the PPV, were put in a room temperature test for 50 h. The devices were driven at a constant current of 6.3 mA/cm². The initial drop (ID) is expressed as the fractional decay during the first 10 hours with respect to the efficiency at the beginning of the test (L₀).

### Lifetime test

Lifetime tests were performed at constant current (6.3 mA/cm²) at 80°C/50% RH.

### Pulse mode test

Pulse mode tests were carried out on a passive matrix display with a MUX16 device. In the pulse mode, the initial drop is the fractional decacy in efficiency with respect to the initial efficiency during the first 100 hours of operation. Initial drop measurements in pulse mode operation were performed with devices driven at 3.5 mA/cm² at room temperature. Lifetime measurements were carried out with an average current density of 3.5 mA/cm² at 80 °C.

### Example 1

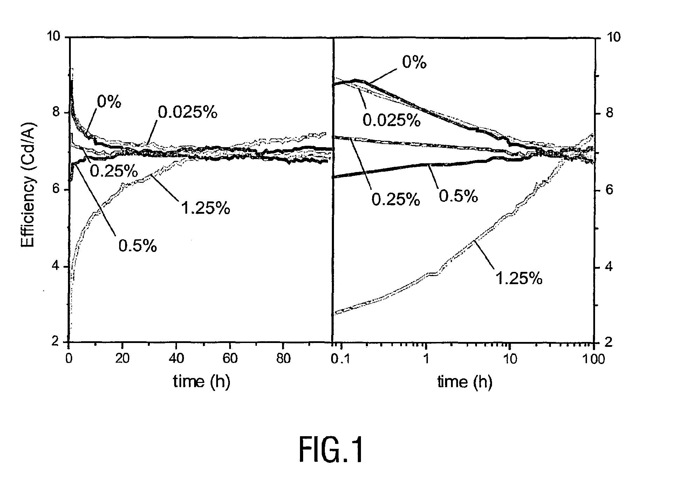

Initial drop and lifetime were measured on 3x3 mm pixel with different concentrations of DTBT and TTBT under the conditions described above. Results are given in Fig. 1 and Table 1 (for DTBT only), wherein L_{0,ID} and L₀,_{L} are the initial luminescences in the initial drop test and the lifetime test, respectively.

**TABLE 1**

| Add. Conc. | L_{0,ID} | ID | L_{0,L} | Lifetime |
|---|---|---|---|---|
| (%) | (Cd/m²) | (fraction) | (Cd/m²) | (hrs) |
| DTBT | | | | |
| 0% | 561 | 0.24 | 456 | 158 |
| 0.025% | 527 | 0.21 | 403 | 172 |
| 0.25% | 394 | 0.03 | 306 | 163 |
| 0.5% | 300 | -0.2 | 303 | 161 |

| TTBT | | | | |
|---|---|---|---|---|
| 0% | 512 | 0.21 | 441 | 158 |
| 0.01% | 527 | 0.21 | 414 | 158 |
| 0.1% | 394 | 0.03 | 427 | 155 |
| 0.2% | 300 | -0.2 | 325 | 166 |

From these results it can be concluded that without an additive, the efficiency drops about 25% in the first 30h (Figure 1). Using the additive, the initial intensity is somewhat lower, but visibly constant from the very beginning. However, the drop in intensity during operation is also reduced considerably. For high concentrations an increase is even observed. After 40 hours about the same efficiency is found in the absence of additive, and for all additive concentrations. The driving voltage is not affected for the low concentrations necessary to remove the initial drop and the voltage changes during operation are similar to those of the samples without additives.
Preferred concentrations are 0.1-0.2% (w/w) for TTBT, and 0.3-0.5% (w/w) for DTBT. Most preferred additives are DTBT and TTBT in a concentration range between 0.1 and 0.5 % (w/w).

### Example 2.

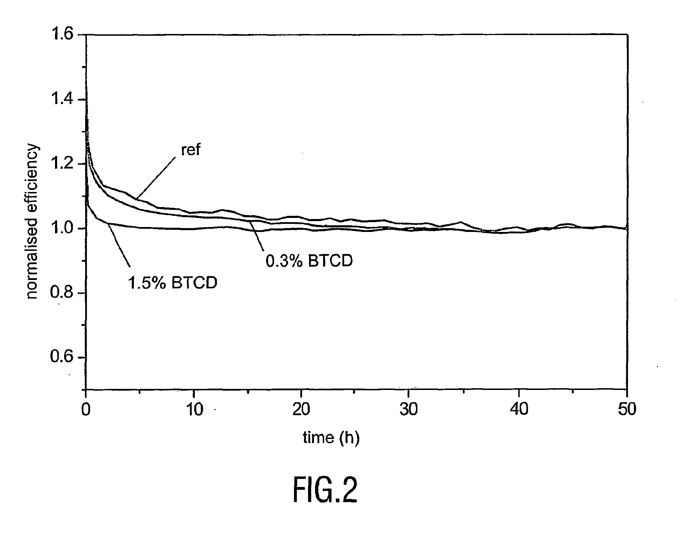

Under the conditions of Example 1, a device was tested with 0.3 and 1.5 % (w/w) of 1,2,4,5-benzenetetracarboxylic dianhydride (BTCD). From the normalized efficiency, presented in Figure 2 it can be concluded that the initial drop can be significantly reduced with 1.5 % (w/w) BTCD, for this application.

### Example 3.

For some products a pulse mode operation is required. Initial drop and lifetime measurements were carried out in a pulse mode test with different concentrations of DTBT and TTBT in yellow PPV. From the results presented in Table 2; it is shown that the additives are able to remove the initial drop also in pulsed operation. Also for matrix displays the lifetime of the polyLED devices is unaffected by the addition of the additives, as is shown in Table 2.

**TABLE 2**

| | L_{0,ID} | ID | L_{0,L} | Lifetime |
|---|---|---|---|---|
| | (Cd/m²) | (fraction) | (Cd/m²) | (hrs) |
| **DTBT** | | | | |
| 0% | 248 | 0.20 | 247 | 355 |
| 0.3% | 169 | 0.02 | 150 | 362 |
| 0.5% | 116 | -0.15 | 130 | 380 |

| **TTBT** | | | | |
|---|---|---|---|---|
| 0% | 230 | 0.21 | 236 | 470 |
| 0.1% | 192 | 0.05 | 159 | 531 |
| 0.2% | 133 | -0.10 | 141 | 471 |

### Comparative Experiment A

Under the conditions of Example 1, devices were tested with various amounts of the additives, not comprising an oligo ring structure with at least four carbonyl groups, as shown in Table 3.

**TABLE 3**

| Abbreviation | Name | Structure |
|---|---|---|
| PpB | Phenyl-p-benzoquinone | 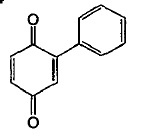 |
| DPBQ | 2,5-diphenyl-1,4-benzoquinone | 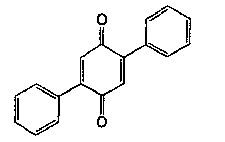 |
| 2-HDF | 2-hydroxydibenzofuran | 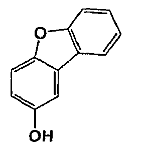 |
| BQ | Benzoquinone | 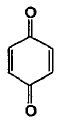 |
| HQ | Hydroquinone | 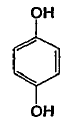 |
| PHQ | Phenylhydroquinone | 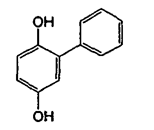 |
| MAP | 4-methylaminophenol | 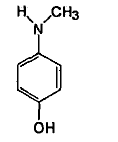 |
| 4-AP | 4-aminophenol | 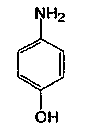 |
| 2,4-DAP | 2,4-diaminophenol | 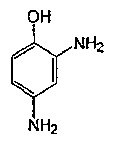 |
| 2-HG | 4-hydroxyphenylglycine | 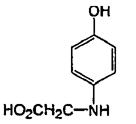 |
| AQ | Anthraquinone | 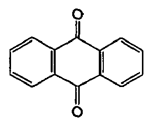 |
| NQ | 2-methyl-1,4-naphtaquinone (vitamin K3) | 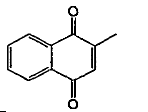 |

The results of all additives tested are summarized in Table 4 below:

**TABLE 4**

| Additive | Efficiency (Cd/A) | Initial drop 0.01-10h (fraction) | Lo (Cd/m²) | Lifetime at 80°C, 50% RH (h) |
|---|---|---|---|---|
| 2% NQ | 7.7 | 0.27 | 462 | 135 |
| 4% NQ | 7.7 | 0.28 | 469 | 135 |
| 8% NQ | 7.4 | 0.23 | 242 | 126 |
| 12% NQ | 7.5 | 0.21 | 389 | 124 |
| 20% NQ | 7.6 | 0.21 | 412 | 122 |
| Ref | 7.5 | 0.27 | 457 | 133 |
| | | | | |
| 0.3% 2-HBF | 8.0 | 0.25 | 371 | 106 |
| 1.5% 2-HBF | 7.9 | 0.26 | 370 | 107 |
| 0.3% BQ | 8.0 | 0.25 | 366 | 107 |
| 1.0% BQ | 8.3 | 0.25 | 363 | 102 |
| 0.3% HQ | 8.1 | 0.27 | | |
| 1.0% HQ | 8.2 | 0.28 | 374 | 95 |
| 0.3% PHQ | 7.8 | 0.22 | | |
| 1.0% PHQ | 8.0 | 0.25 | 440 | 101 |
| Ref. | 7.0 | 0.24 | 367 | 100 |
| | | | | |
| 0.3% MAP | 8.0 | 0.21 | | |
| 1.5% MAP | 8.1 | 0.25 | 351 | 122 |
| 0.3% 4-AP | 7.4 | 0.23 | | |
| 1.5% 4-AP | 8.6 | 0.28 | 397 | 107 |
| 0.3% 2,4-DAP | 8.2 | 0.26 | 342 | 114 |
| 1.5% 2,4-DAP | 8.0 | 0.26 | 375 | 12 |
| 0.3% AQ | 7.9 | 0.25 | | |
| 1.5% AQ | 7.8 | 0.23 | 319 | 119 |
| Ref | 7.4 | 0.24 | 356 | 111 |
| | | | | |
| 0.3% 2-HG | 8.82 | 0.21 | 391 | 117 |
| 1.5% 2-HG | 7.84 | 0.23 | 400 | 129 |
| 0.3% PpB | 7.94 | 0.25 | 353 | 100 |
| 1.5% PpB | 7.44 | 0.21 | 320 | 123 |
| 0.3% DPBQ | 7.24 | 0.23 | 326 | 124 |
| 1.5% DPBQ | 5.91 | 0.24 | 232 | 127 |

None of these additives have an effect on the initial drop of the efficiency of the luminescent layer.

### Comparative Experiment B

A hypothesis for the working of the additives was that the reduction level of the additives should be lower in energy compared to the lowest empty level (LUMO) of the host polymer, showing an initial drop. This Comparative Experiment is to verify the hypothesis that the initial drop phenomenon originates from electron traps within the polymer. Therefore the oxidation and reduction potentials for various additives from Table 4 were determined. Oxidation and reduction are measured with cyclovoltametry, with ferrocene as a reference. The ionisation potential (Iₚ) is calculated via Iₚ=- (Eₒₓ+4.8). The electron affinity (Eₐ) is calculated via Eₐ=- E_{red}+4.8). The results are shown in Table 5.

**TABLE 5**

| Additive | Oxidation | Iₚ | Reduction | Eₐ |
|---|---|---|---|---|
| | (V) | (eV) | (V) | (eV) |
| Yellow PPV | | | | -2.9 |
| DTBT | | | -1.07 (1) | -3.73 (1) |
| | | | -1.59 (2) | -3.21 (2) |
| TTBT | | | -1.05 (1) | -3.75 (1) |
| | | | -1.57 (2) | -3.23 (2) |
| PpB | | | -0.87 (1) | -3.93 (1) |
| | | | -1.53 (2) | -3.27 (2) |
| PBQ | | | -0.87 (1) | -3.93 (1) |
| | | | -1.53 (2) | -3.27 (2) |
| 2-HBF | 1.11 | -5.91 | | |
| BQ | | | -0.89 (1) | -3.91 (1) |
| | | | -1.55 (2) | -3.25 (2) |
| HQ | 0.73 | -5.53 | | |
| PHQ | 0.69 | -5.49 | | |
| 4-AP | 0.03 | -4.83 (1) | | |
| | 0.20 | -5.00 (2) | | |
| AQ | | | -1.30 (1) | -3.50 (1) |
| | | | -1.84 (2) | -2.96 (2) |
| BTCD | | | -0.91 (1) | -3.89 (1) |
| | | | -1.55 (2) | -3.25 (2) |

Based on the energy levels it would be expected that BQ, PBQ, PpB, and AQ should eliminate the initial drop as well. As this is not the case as can be seen in Table 4, the effect on the initial drop is not caused by the presence of an electron trapping compound.

### Comparative Experiment C

Patent US 5,629,389 describes an increased efficiency for PPV's by adding high concentrations of hindered phenols to the polymer. In the patent examples are given with 2,6-di-tert-butyl-4-methylphenol (DBMP) and 2,4,6-tri-tert-butyl phenol (TBP) in BCA-PPV and MEH PPV. When concentrations up to 50% have been used the efficiency of the polyLEDs should be four fold higher.

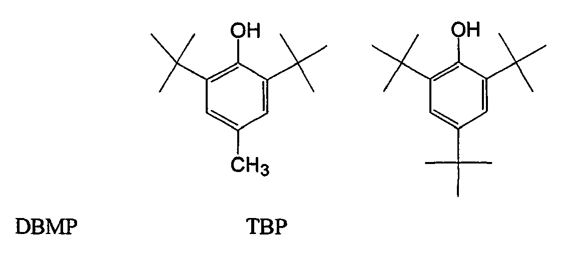

To check the effect on the initial drop, both DBMP and TBP were added to yellow PPV.

**TABLE 6**

| Additive | % | L₀ (Cd/m²) | Lifetime (h) | ID |
|---|---|---|---|---|
| DBMP | 0 | 533 | 184 | 0.26 |
| DBMP | 0.4 | 377 | 101 | 0.22 |
| DBMP | 4 | 204 | 18 | -0.02 |
| DBMP | 40 | 186 | 57 | 0.10 |
| TBP | 0 | 533 | 184 | 0.26 |
| TBP | 0.4 | 427 | 136 | 0.26 |
| TBP | 4 | 163 | 35 | 0.07 |
| TBP | 40 | 247 | 13 | -0.01 |

Samples have been put in lifetime testing at the same initial brightness (∼300 Cd/m²). The results are summarized in Table 6. For concentrations below 3 % of additives no effect on the initial drop is observed. For higher concentrations, although there is an effect on the initial drop, the initial luminescence and the lifetime are reduced to a level which is far below acceptable. For these additives no concentration can be found, for suppressing the initial drop in the efficiency of light emission without significant decrease of the operational lifetime with respect to the lifetime of the electroluminescent material used as such.

## Claims

1. Electroluminescent composition comprising an electroluminescent material containing an aryl vinylene and an additive for suppressing a drop in initial light emission efficiency observed when an electroluminescent device comprising the electroluminescent material as such is driven to emit light.

2. Electroluminescent composition according to claim 1, wherein the additive comprises an oligo ring structure with at least four carbonyl groups.

3. Electroluminescent material according to claim 2, wherein the additive comprises at least three fused rings.

4. Electroluminescent composition according to claim 3, wherein the additive is selected from one of the following compounds:

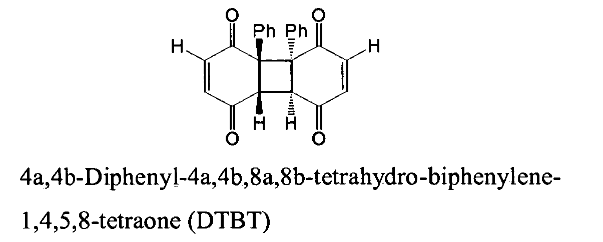

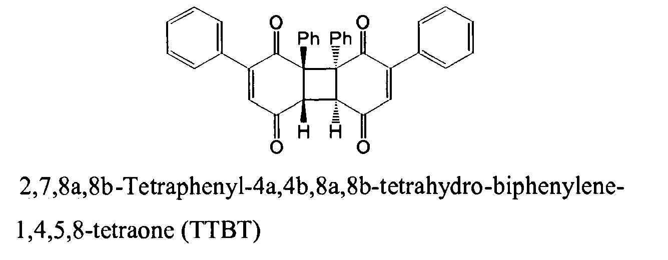

5. Electroluminescent composition according to any of claims 1- 4, wherein the additive is present in a concentration of between 0.1 and 3 % by weight with respect to the electroluminescent material.

6. Electroluminescent composition according to any of claims 1- 5, wherein the aryl vinylene containing material comprises a substituted poly(p-phenylene vinylene) or a substituted mono, or oligo phenyl vinylene.

7. Electroluminescent device comprising an electroluminescent composition according to any of claims 1-6.

## Patentansprüche

1. Elektrolumineszierende Zusammensetzung mit einem elektrolumineszierenden Material, welches ein Arylvinylen und ein Additiv enthält, um einen Abfall der anfänglichen Lichtemissionseffizienz, welcher beobachtet wird, wenn eine das elektrolumineszierende Material enthaltende, elektrolumineszierende Anordnung als solche so gesteuert wird, dass sie Licht emittiert, zu unterdrücken.

2. Elektrolumineszierende Zusammensetzung nach Anspruch 1, wobei das Additiv eine Oligo-Ringstruktur mit mindestens vier Carbonylgruppen aufweist.

3. Elektrolumineszierendes Material nach Anspruch 2, wobei das Additiv mindestens drei anellierte Ringe aufweist.

4. Elektrolumineszierende Zusammensetzung nach Anspruch 3, wobei das Additiv aus einer der folgenden Verbindungen ausgewählt wird:

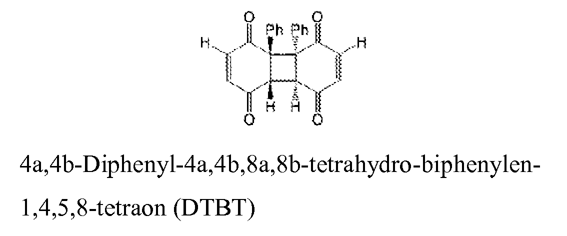

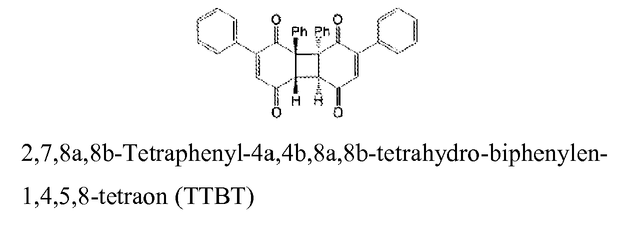

5. Elektrolumineszierende Zusammensetzung nach einem der Ansprüche 1 - 4, wobei das Additiv gegenüber dem elektrolumineszierenden Material in einer Konzentration zwischen 0,1 und 3 Gew.% vorhanden ist.

6. Elektrolumineszierende Zusammensetzung nach einem der Ansprüche 1 - 5, wobei das Arylvinylen enthaltende Material ein substituiertes Poly(p-phenylenvinylen) oder ein substituiertes Mono- oder Oligophenylvinylen enthält.

7. Elektrolumineszierende Anordnung mit einer elektrolumineszierenden Zusammensetzung nach einem der Ansprüche 1 - 6.

## Revendications

1. Composition électroluminescente comprenant un matériau électroluminescent contenant un arylvinylène et un additif pour supprimer une chute du rendement initiale d'émission de lumière observée lorsqu'un dispositif électroluminescent comprenant le matériau électroluminescent tel quel est excité pour émettre de lumière.

2. Composition électroluminescente selon la revendication 1, dans laquelle l'additif comprend une structure cyclique oligo avec au moins quatre groupements carbonyle.

3. Matériau électroluminescent selon la revendication 2, dans lequel l'additif comprend au moins trois cycles condensés.

4. Composition électroluminescente selon la revendication 3, dans laquelle l'additif est choisi parmi un des composés suivants :

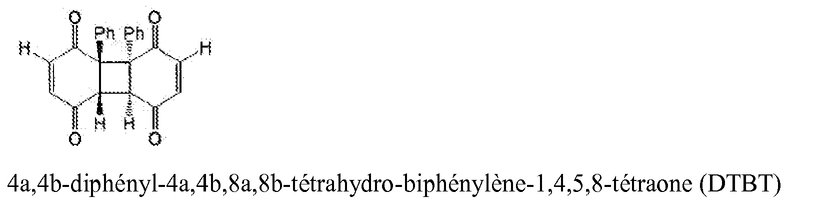

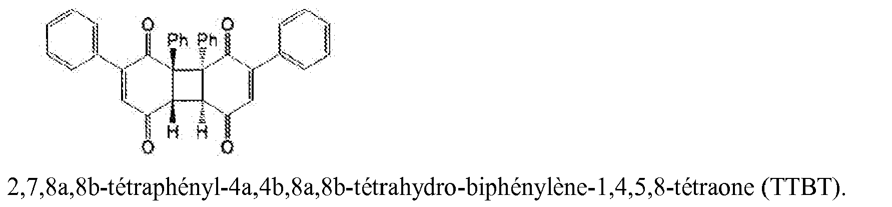

5. Composition électroluminescente selon l'une quelconque des revendications 1 à 4, dans laquelle l'additif est présent en concentration de 0,1 à 3 % en poids par rapport au matériau électroluminescent.

6. Composition électroluminescente selon l'une quelconque des revendications 1 à 5, dans laquelle le matériau contenant de l'arylvinylène comprend un poly(p-phénylènevinylène) substitué ou un mono- ou oligophénylviylène substitué.

7. Dispositif électroluminescent comprenant une composition électroluminescente selon l'une quelconque des revendications 1 à 6.
